(19) Europäisches Patentamt
European Patent Office
Office européen des brevets

(11) **EP 3 706 275 B1**

(12) **EUROPEAN PATENT SPECIFICATION**

(45) Date of publication and mention
of the grant of the patent:
**14.07.2021 Bulletin 2021/28**

(51) Int Cl.:
*H02J 3/00* (2006.01)          *G01R 19/25* (2006.01)
*H02J 3/46* (2006.01)

(21) Application number: **19215223.9**

(22) Date of filing: **11.12.2019**

(54) **METHOD AND SYSTEM TO ESTIMATE EQUIVALENT PARAMETERS FOR AN EXTERNAL NETWORK**

VERFAHREN UND SYSTEM ZUR SCHÄTZUNG VON ÄQUIVALENTEN PARAMETERN FÜR EIN EXTERNES NETZWERK

PROCÉDÉ ET SYSTÈME POUR ESTIMER DES PARAMÈTRES ÉQUIVALENTS POUR UN RÉSEAU EXTERNE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.03.2019 IN 201941009035**

(43) Date of publication of application:
**09.09.2020 Bulletin 2020/37**

(73) Proprietor: **Hitachi, Ltd.**
**Tokyo 100-8280 (JP)**

(72) Inventors:
• **NERADHALA, Nagaraj**
**560055 Bangalore (IN)**
• **NAGENDRAN, Mayank**
**560055 Bangalore (IN)**

(74) Representative: **MERH-IP Matias Erny Reichl Hoffmann**
**Patentanwälte PartG mbB**
**Paul-Heyse-Strasse 29**
**80336 München (DE)**

(56) References cited:
**US-A1- 2004 083 087     US-A1- 2014 244 065**

• **GEORGE N KORRES: "A Partitioned State Estimator forExternal Network Modeling", IEEE TRANSACTIONS ON POWER SYSTEMS, IEEE SERVICE CENTER, PISCATAWAY, NJ, US, vol. 17, no. 3, 31 August 2002 (2002-08-31), XP011079174, ISSN: 0885-8950**
• **EDUARDO WERLEY S DOS ANGELOS ET AL: "Multi-Area State Estimation with PMU and external system modeling", 2012 IEEE POWER AND ENERGY SOCIETY GENERAL MEETING ; SAN DIEGO, CALIFORNIA, USA; 22 - 26 JULY 2012, IEEE, PISCATAWAY, NJ, 22 July 2012 (2012-07-22), pages 1-7, XP032466202, DOI: 10.1109/PESGM.2012.6345584 ISBN: 978-1-4673-2727-5**
• **ANGELOS EDUARDO WERLEY S ET AL: "Bad data processing for real-time equivalent networks", 2015 IEEE POWER & ENERGY SOCIETY GENERAL MEETING, IEEE, 26 July 2015 (2015-07-26), pages 1-5, XP033225167, DOI: 10.1109/PESGM.2015.7286458 [retrieved on 2015-09-30]**
• **MONTICELLI A ET AL: "A Method That Combines Internal State Estimation and External Network Modeling", IEEE TRANSACTIONS ON POWER APPARATUS AND SYSTEMS, IEEE INC. NEW YORK, US, vol. PAS-100, no. 1, 31 January 1985 (1985-01-31), pages 91-103, XP011170829, ISSN: 0018-9510**

**Description**

The following specification particularly describes the invention and the manner in which it is to be performed.

## TECHNICAL FIELD

The present subject matter is related in general to power system with internal and external networks, more particularly, but not exclusively to estimate one or more equivalent parameters for at least one external network associated with an internal network in a power system.

## BACKGROUND

Electric power system is a group of electric networks which provision generation, transmission, distribution, communication, and other facilities of electric power. The electric networks are physically connected within each other in the electric power system. The electric power system includes control centres which monitor corresponding electric networks and receive telemetered data of real time measurements for analysing the corresponding electric network. An electric network for which the telemetered data may be accessed and monitored may be referred to as internal system or internal area or internal network. The internal network may be connected to neighbouring electric networks and such neighbouring electric networks may be referred to as external system or external area or external network. The internal network may be connected with external networks through boundary buses. Effect of the external network on the internal network in steady state is reflected by real power flow and reactive power flow from the external network through the boundary buses. Set of real time measurements is processed for state estimation of energy management system located at control centre. By processing, best estimate of present state of the internal network may be obtained. Once the state is obtained, other quantities of interest for real time applications for the internal network may be computed.

In the power system, it is known that the internal network may face problems or issues due to the external networks. Typically, the power system consists of several areas owned by various utilities and some of the utilities may be reluctant to share complete system information with other utilities. Further, there may be practical limitations on computational resources of the power system. Such scenarios may lead to problems and issues.

In real time applications, information of an internal network may be obtained from a state estimator. In off-line studies, it is simply the steady state load flow solution. The external network may comprise any number of mutually connected separate control areas, or it may be unobservable part. The external network modelling plays a crucial role for real time application called security assessment of the power system. A power system is said to be secure if no contingency in the internal network will cause overload, abnormal voltages and so on. To evaluate consequence of the contingency, which is futuristic case, state estimation is no longer be used because there are no measurements available of the external network.

Existing systems disclose to evaluate contingency by simulating a load flow model for the internal network. The load flow model for the contingent case may be available from the state estimator and it would be possible to run the load flow model just for the internal network if flows from the external network to the boundary buses are known. However, response of the external network to the contingency makes the flows from the external system to the boundary buses different from their actual or present values. Therefore, for online contingency evaluation, when external networks information is known partially or fully, the response from the external networks, for change in the internal networks, need to be estimated. By such estimation power system, reliability and stability may be maintained.

Conventional systems teach to require measurements of the external network to predict equivalent of the external network. Such equivalent may be further used for the state estimation. Some of the conventional systems may disclose a multiperiod least-squares estimation model for external equivalent parameter. In such conventional system, according to boundary nodes and state information of an internal network in multiple periods, constrain relation between the external parameters and external nodes may be determined. Further, the equivalent parameter may be solved using Gauss-Newton method to retrieve minimal measurements from the external network. This may include power injections at each node of the external network. However, such conventional systems still rely on the external network measurements. Also, the measurements may be required at multiple time periods which is not feasible for real-time operational applications, as each time period or each internal network state estimation may last for few minutes. For such conventional systems, when no measurements, minimal or partial measurements are available, response for internal network events may not be captured accurately. Also, with few assumptions in the external network, one or more equivalent external network may be determined. However, such assumptions may not provide accurate equivalents.

GEORGE N KORRES: "A Partitioned State Estimator for External Network Modeling", IEEE TRANSACTIONS ON POWER SYSTEMS, IEEE SERVICE CENTER, PISCATAWAY, NJ, US, vol. 17, no. 3, 1 August 2002 (2002-08-01) discloses a partitioned state estimation (SE) method for real-time external network modeling. The method utilizes an unreduced model of the external network and it is based on the SE approach. Since the external network model must not contaminate the internal system state and power mismatches at boundary buses should be minimal, the boundary measurements (tie-line flows and boundary injections) should be critical. Any type of real-time measurements (power flows and injections) can be used. The entire system state is computed by a two-pass method based on measurement model partitioning. The method is based on the fast decoupled model and it can be easily implemented by modifying an existing SE program.

EDUARDO WERLEY S DOS ANGELOS ET AL: "Multi-Area State Estimation with PMU and external system modeling", 2012 IEEE POWER AND ENERGY SOCIETY GENERAL MEETING; SAN DIEGO, CALIFORNIA, USA; 22 - 26 JULY 2012, IEEE, PISCATAWAY, NJ, 22 July 2012 (2012-07-22), pages 1-7 discloses a Multi-Area State Estimation strategy suited to interconnected networks that incorporates the traditional external equivalent technique into the model. Given the relevante of external and boundary systems modeled to wide area state estimation precision, the potential of synchrophasors to provide more precise external modeling and yield better internal and boundary estimate is demonstrated.

US 2004/083087 A discloses a method, computer program and data processing system for simulating an electrical power transmission network. A representation of the transmission network represents a power transmission section of the network linking a pair of buses, an internal network section connected to said pair of buses and an external network section comprising at least one adjoining network that is connected to the internal network section. A composite network section that comprises both the external and the internal network section is represented by a ward equivalent circuit.

The information disclosed in this background of the disclosure section is only for enhancement of understanding of the general background of the invention and should not be taken as an acknowledgement or any form of suggestion that this information forms the prior art already known to a person skilled in the art.

## SUMMARY

In an embodiment, the present disclosure relates to a method to estimate one or more equivalent parameters for at least one external network associated with an internal network in a power system. For the estimation, a simplified network is established for a power system comprising an internal network and at least one external network. The simplified network may be established based on at least one of state variables and measurements of the internal network and the one or more boundary buses of the power system. The at least one external network is represented as a bus with plurality of predefined state variables for the at least one external network. Further, one or more network parameters, such as power flow or state variables in the one or more boundary buses, is estimated for the at least one external network, based on the simplified network and the plurality of predefined state variables. The one or more network parameters are estimated using an optimization technique. Further, for the estimation of the one or more equivalent parameters, tuning of the one or more network parameters is performed with respect to the state variables and the measurements of the internal network and the one or more boundary buses. The tuning comprises performing a state estimation of the power system using the one or more network parameters, determining a residual associated with the state estimation of the power system, where the residual is compared with a threshold value, and optimizing the one or more network parameters for performing further state estimation of the power system when the residual is determined to be greater than the threshold value. The optimizing the one or more network parameters is performed by splitting the bus for the one or more boundary buses and varying values of the one or more network parameters for each of the one or more boundary buses, to minimize residuals associated with at least one of real power, voltage, angle, reactive power of the internal network and the one or more boundary buses. The tuning is performed until the residual is determined to be lesser than the threshold value. Upon optimizing, the one or more network parameters are provided as the as one or more equivalent parameters for the at least one external network.

In an embodiment, the present disclosure relates to an estimation system to estimate one or more equivalent parameters for at least one external network associated with an internal network in a power system. The estimation system includes a processor and a memory communicatively coupled to the processor. The memory stores processor-executable instructions, which on execution cause the processor to estimate the one or more equivalent parameters. For the estimation, a simplified network is established for a power system comprising an internal network and at least one external network. The simplified network may be established based on at least one of state variables and measurements of the internal network and the one or more boundary buses of the power system. The at least one external network is represented as a bus with plurality of predefined state variables for the at least one external network. Further, one or more network parameters, such as power flow or state variables in the one or more boundary buses, is estimated for the at least one external network, based on the simplified network and the plurality of predefined state variables. The one or more network parameters are estimated using an optimization technique. Further, for the estimation of the one or more equivalent parameters, tuning of the one or more network parameters is performed with respect to the state variables and the measurements of the internal network and the one or more boundary buses. The tuning comprises performing a state estimation of the power system using the one or more network parameters, determining a residual associated with the state estimation of the power system, where the residual is compared with a threshold value, and optimizing the one or more network parameters for performing further state estimation of the power system when the residual is determined to be greater than the threshold value. The tuning is performed until the residual is determined to be lesser than the threshold value. Upon optimizing, the one or more network parameters are provided as the as one or more equivalent parameters for the at least one external network. The optimizing of the one or more network parameters is performed by splitting the bus for the one or more boundary buses and varying values of the one or more network parameters for each of the one or more boundary buses, to minimize residuals associated with at least one of real power, voltage, angle, reactive power of the internal network and the one or more boundary buses.

The foregoing summary is illustrative only and is not intended to be in any way limiting. In addition to the illustrative aspects, embodiments, and features described above, further aspects, embodiments, and features will become apparent by reference to the drawings and the following detailed description.

## BRIEF DESCRIPTION OF THE ACCOMPANYING DRAWINGS

The accompanying drawings, which are incorporated in and constitute a part of this disclosure, illustrate exemplary embodiments and, together with the description, serve to explain the disclosed principles. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and regarding the accompanying figures, in which:

**Figure 1** shows an exemplary environment of an estimation system to estimate one or more equivalent parameters for at least one external network, in accordance with some embodiments of the present disclosure;

**Figure 2** shows a detailed block diagram of an estimation system to estimate one or more equivalent parameters for at least one external network, in accordance with some embodiments of the present disclosure;

**Figures 3a** and **3b** illustrate exemplary embodiments of a power system for establishing a simplified network of the power system, in accordance with some embodiments of present disclosure;

**Figures 4a, 4b, 4c and 4d** illustrate exemplary embodiments of a power system for establishing a simplified network of the power system, in accordance with some embodiments of present disclosure;

**Figures 5a** and **5b** illustrate exemplary embodiments to optimize one or more network parameters for tuning, in accordance with some embodiments of present disclosure;

**Figure 6** illustrates a flowchart showing an exemplary method to estimate one or more equivalent parameters for at least one external network, in accordance with some embodiments of present disclosure; and

**Figure 7** illustrates a block diagram of an exemplary computer system for implementing embodiments consistent with the present disclosure.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor, whether such computer or processor is explicitly shown.

## DETAILED DESCRIPTION

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below.

The terms "comprises", "comprising", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a system or apparatus proceeded by "comprises... a" does not, without more constraints, preclude the existence of other elements or additional elements in the system or method.

The terms "includes", "including", or any other variations thereof, are intended to cover a non-exclusive inclusion, such that a setup, device, or method that includes a list of components or steps does not include only those components or steps but may include other components or steps not expressly listed or inherent to such setup or device or method. In other words, one or more elements in a system or apparatus proceeded by "includes... a" does not, without more constraints, preclude the existence of other elements or additional elements in the system or method.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

Present disclosure relates an estimation system, in a power system, for estimating equivalent parameters for an external network. The present disclosure teaches to establish or frame a relationship at boundary and internal network nodes, with assumed parameters at external network. A simplified network is established for the power system and network parameters are estimated using an optimization method. Using the network parameters, state estimation is computed for the whole power system. The network parameters are tuned with respect to the internal network and boundary buses, to minimize residual associated with the state estimation. The network parameters for minimal value of the residual are considered to be the equivalent parameters. By the proposed method, the need for knowing measurement or state variables of the external network may be eliminated.

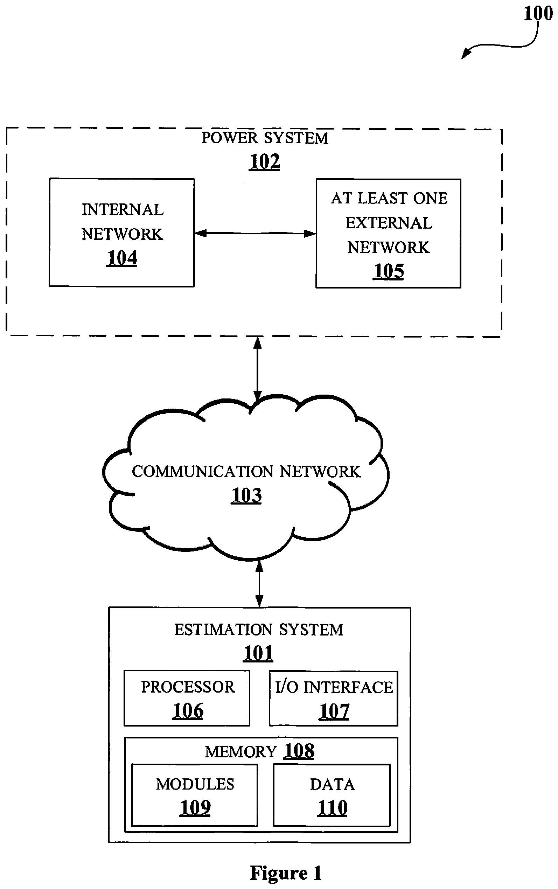

Figure 1 shows an exemplary environment 100 of an estimation system 101 to estimate one or more equivalent parameters for at least one external network in a power system. The exemplary environment 100 may include the estimation system 101, power system 102, and a communication network 103. The estimation system 101 may be configured to perform the steps of the present disclosure. The power system 102 may be associated with an internal network 104 and at least one external network 105. The power system 102 may be configured to provision generation, transmission, distribution, communication, and other facilities, of electric power. The internal network 104 and the at least one external network 105 may be physically connected within each other in the power system 102. The internal network 104 may be connected to the at least one external bus 105, through one or more boundary buses. Plurality of state variable and one or more measurements associated with the internal network 104 may be known in the power system 102. However, plurality of state variable and one or more measurements associated with the at least one external network 105 may not be known in the power system 102. The estimation system 101 may be configured to communicate with the power system 102 via the communication network 103. In an embodiment, the estimation system 101, may be a part of the internal network 104 (not shown in the figure). In an embodiment, the communication network 103 may include, without limitation, a direct interconnection, Local Area Network (LAN), Wide Area Network (WAN), Controller Area Network (CAN), wireless network (e.g., using Wireless Application Protocol), the Internet, and the like.

Further, the estimation system 101 may include a processor 106, I/O interface 107, and a memory 108. In some embodiments, the memory 108 may be communicatively coupled to the processor 106. The memory 108 stores instructions, executable by the processor 106, which, on execution, may cause the estimation system 101 to estimate the one or more equivalent parameters of the at least one external network 105, as disclosed in the present disclosure. In an embodiment, the memory 108 may include one or more modules 109 and data 110. The one or more modules 109 may be configured to perform the steps of the present disclosure using the data 110, to estimate the one or more equivalent parameters. In an embodiment, each of the one or more modules 109 may be a hardware unit which may be outside the memory 108 and coupled with the estimation system 101. The estimation system 101 may be implemented in a variety of computing systems, such as a laptop computer, a desktop computer, a Personal Computer (PC), a notebook, a smartphone, a tablet, e-book readers, a server, a network server, a cloud-based server, and the like. In an embodiment, the estimation system may receive and transmit data via the I/O interface through the communication network 103.

For the estimation of the one or more equivalent parameters, the estimation system 101 may be configured to establish a simplified network for the power system 102. The simplified network may be established based on the plurality of state variables of the internal network 104. The at least one external network 105 may be represented as a bus with plurality of predefined state variables for the at least one external network 105. In an embodiment, the estimation system 101 may be configured to determine the one or more boundary buses and corresponding flow of real power and reactive power flow associated with the internal network 104. The one or more boundary buses may be determined based on the plurality of state variables of the internal network 104. Further, the estimation system 101 may be configured to extend the internal network 104 along with the one or more boundary buses using the bus through one or more impendences, for establishing the simplified network.

Upon establishing the simplified network, the estimation system 101 may be configured to estimate one or

5

more network parameters for the at least one external network 105. The one or more network parameters may be estimated based on the simplified network and the plurality of predefined state variables. The one or more network parameters may be estimated using an optimization technique. In an embodiment, any optimization technique, known to a person skilled in the art, may be implemented for estimating the one or more network parameters.

Further, the estimation system 101 may be configured to perform tuning of the one or more network parameters is performed. The tuning may be performed with respect to the state variables and measurements of the internal network and the one or more boundary buses. The tuning comprises performing a state estimation of the power system 102 using the one or more network parameters. A residual associated with the state estimation of the power system 102 may be determined and compared with a threshold value. Further, when the residual is determined to be greater than the threshold value, one or more network parameters are optimized for further state estimation of the power system 102. In an embodiment, optimizing the one or more network parameters may be performed to reduce a mismatch associated with at least one of power flow and state variables in the one or more boundary buses. In an embodiment, optimizing the one or more network parameters may be performed based on sensitivity factors associated with the one or more network parameters of the at least one external network 105. In an embodiment, optimizing the one or more network parameters is performed by splitting the bus for the one or more boundary buses and varying values of the one or more network parameters for each of the one or more boundary buses. The values of the one or more network parameters may be varied to minimize residuals associated with at least one of real power, voltage, angle, reactive power of the internal network 104 and the one or more boundary buses. In an embodiment, optimizing the one or more network parameters may be performed by injecting one or more shunts in the simplified network and adjusting values of the one or more shunts to optimize the one or more network parameters.

The estimation system 101 may perform tuning until the residual is determined to be lesser than the threshold value. Upon tuning and optimizing of the one or more network parameters until the residual is lesser than the threshold value, the optimized one or more network parameters are provided as the as one or more equivalent parameters for the at least one external network 105.

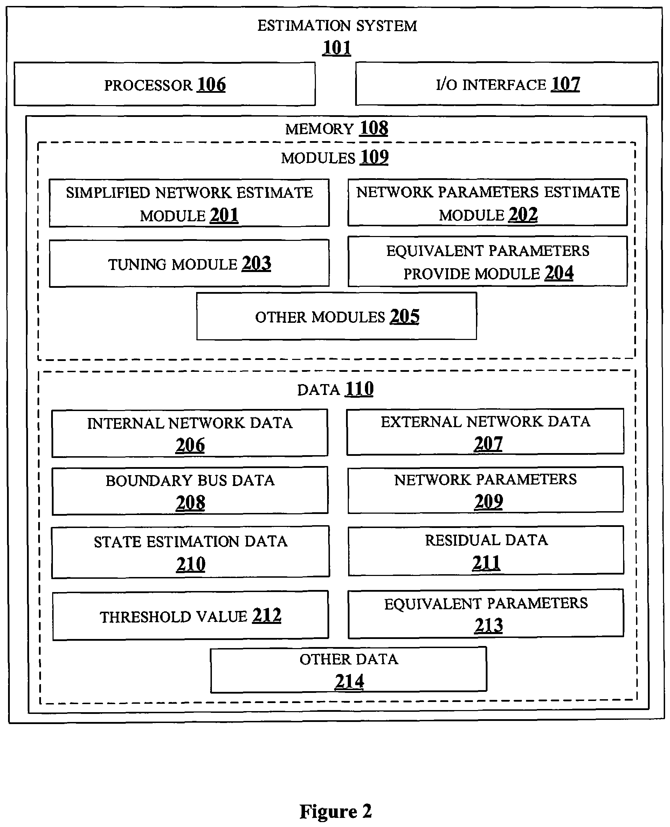

**Figure 2** shows a detailed block diagram of the estimation system 101 to estimate the one or more equivalent parameters for at least one external network, in accordance with some embodiments of the present disclosure.

The data 110 and the one or more modules 109 in the memory 108 of the estimation system 101 is described herein in detail.

In one implementation, the one or more modules 109 may include, but are not limited to, a simplified network establish module 201, a network parameters estimate module 202, a tuning module 203, equivalent parameters provide module 204 and one or more other modules 205, associated with the estimation system 101.

In an embodiment, the data 110 in the memory 108 may include internal network data 206, external network data 207, boundary bus data 208, network parameters 209 (also referred to as one or more network parameters 209), state estimation data 210, residual data 211 (also referred to as residual 211), threshold value 212, equivalent parameters 213 (also referred to as one or more equivalent parameters 213) and other data 214 associated with the estimation system 101.

In an embodiment, the data 110 in the memory 108 may be processed by the one or more modules 109 of the estimation system 101. In an embodiment, the one or more modules 109 may be implemented as dedicated units and when implemented in such a manner, said modules may be configured with the functionality defined in the present disclosure to result in a novel hardware. As used herein, the term module may refer to an Application Specific Integrated Circuit (ASIC), an electronic circuit, a Field-Programmable Gate Arrays (FPGA), Programmable System-on-Chip (PSoC), a combinational logic circuit, and/or other suitable components that provide the described functionality.

The one or more modules 109 of the present disclosure function to estimation the one or more equivalent parameters for the at least one external network. The one or more modules 109 along with the data 110, may be implemented in any system, for estimating the one or more equivalent parameters.

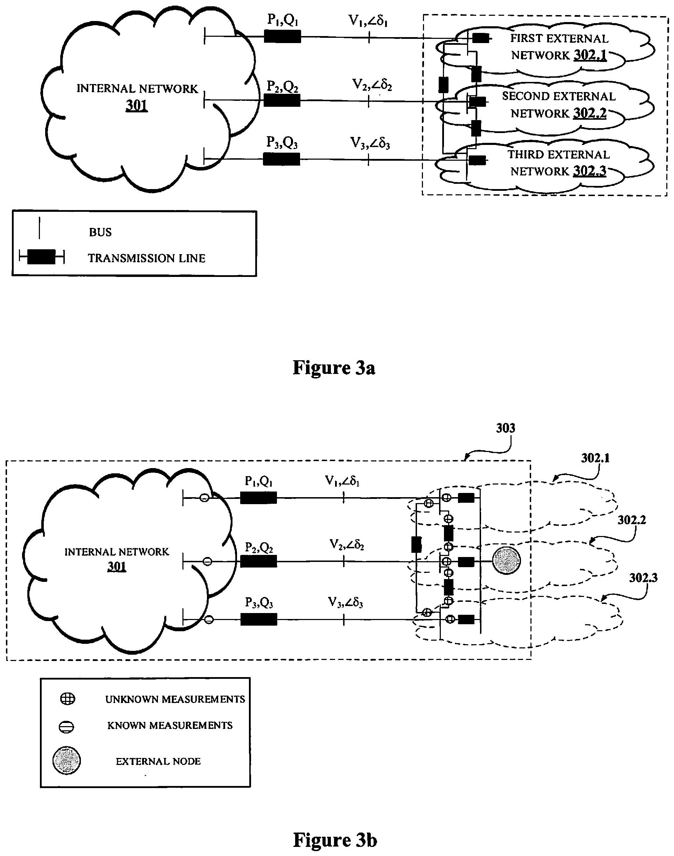

A power system may include an internal network and at least one external network. The internal network may be connected via one or more boundary buses to the external network. Consider an exemplary representation of the power system 102 as shown in **Figure 3a.** The power system includes an internal network 301 connected to a first external network 302.1, a second external network 302.2 and a third external network 302.3, via one or more boundary buses and transmission lines. In an embodiment, the internal network 301 may be connected to any number of external networks. The internal network 301 may be associated with plurality of state variable and plurality of measurements. The plurality of state variables may include voltage, current and angle at nodes of the internal network 301. The plurality of measurements may include reactive power and real power flowing in buses associated with the internal network 301. In an embodiment, said plurality of state variables and said plurality of measurements may be stored as the internal network data 206 in the memory 108 of the estimation system 101. In an embodiment, each of the one or more boundary buses may be associated with corresponding plurality of state variables and corresponding plurality of measurements. The plurality of state variables may include voltage, current and angle at respective boundary bus. The plurality of measurements may include reactive power and real power flowing in respective boundary bus. In an embodiment, said plurality of state variable and said plurality of measurements associated with each of the one or more boundary buses, may be stored as respective boundary bus data 208 in the memory 108 of the estimation system 101. In an embodiment, each of the external networks 302.1, 302.2 and 302.3 may be associated with plurality of state variables and plurality of measurements. Since, in the present disclosure, the plurality of state variables and the plurality of measurements are unknown, said plurality of state variables and said plurality of measurements may be assumed and stored in the memory 108 as the external network data 207. The plurality of state variables may include voltage, current and angle at nodes of respective external network. The plurality of measurements may include reactive power and real power flowing in buses associated with respective external network. In an embodiment, said plurality of state variables and said plurality of measurements of each of the external networks 302.1, 302.2 and 302.3 may be stored as the external network data 207 in the memory 108 of the estimation system 101. Similarly, for any of the power system including an internal network and any number of external network, the memory 108 of the estimation system 101 may store the corresponding internal network data 206, external network data 207 and boundary bus data 208. In an embodiment, the transmission lines in the power system 102 may be considered to be zero impendence lines, for estimating the equivalents of the first external network 302.1, the second external network 302.2 and the third external network 302.3. If the transmission lines are not considered to be zero impedance lines, external buses of the first external network 302.1, the second external network 302.2 and the third external network 302.3 may be assumed with state variable values $V_1$ and $<\delta_1$, $V_2$ and $<\delta_2$, and $V_3$ and $<\delta_3$, respectively.

In an embodiment, in the present disclosure, the internal network 301 may be assumed to have sufficient and adequate number of measurements accessed from the internal network 301. As shown in **Figure 3b,** known measurements may include real power flows, reactive power flows, injections, and voltage measurement and so on. In an embodiment, the plurality of state variables i.e., voltage and angles may be computed at the internal network 301 and the one or more boundary buses. Further, the real power flow and the reactive power flow of the internal network 301 and the one or more boundary buses may be computed from computed plurality of state variables. As shown in the **Figure 3b,** the plurality of measurements and the plurality of state variables may be unknown for the external networks 302.1, 302.2 and 302.3.

In the present disclosure, initially, the simplified network establish module 201 may be configured to establish a simplified network for the power system. An exemplary representation of a simplified network 303 for the power system is shown in **Figure 3b.** In an embodiment, the simplified network 303 may be established by extending the internal network 301 along with the one or more boundary buses using a bus through one or more impendences. The bus may also be referred to as reference bus or swing bus. The bus may be connected to an external node. In an embodiment, the external node may be referred to as reference node. In an embodiment, the simplified network 303 may be associated with more than one reference nodes. In that case, each of tie-lines in the power system may be associate with a reference node, connected via the reference bus. The one or more impedances, along with the bus and the external node may represent the external networks 302.1, 302.2 and 302.3.

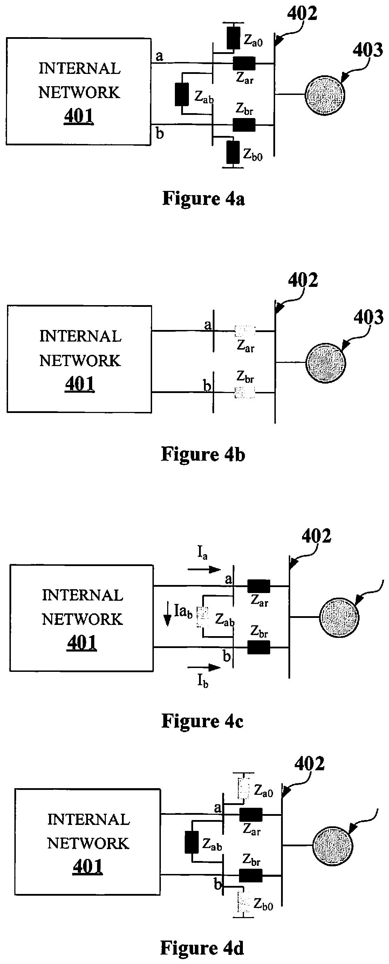

Consider a simplified network illustrated in **Figure 4a,** where "a" and "b" are boundary buses connected between an internal network 401 and at least one external network. The external networks 302.1, 302.2 and 302.3 are represented using impedances $Z_{ab}$, $Z_{ar}$, $Z_{br}$, $Z_{a0}$ and $Z_{b0}$, bus 402 and a reference node 403.

The impedance $Z_{ab}$ may be equivalent impedance at the boundary buses "a" and "b" computed using equation 1 given below:

$$Z_{ab} = r_{ab} + j \; x_{ab} \ldots \ldots \ldots (1)$$

The impedance $Z_{ar}$ may be equivalent impedance at the boundary bus "a" and the reference bus computed using equation 2 given below:

$$Z_{ar} = r_{ar} + j \; x_{ar} \ldots \ldots \ldots (2)$$

The impedance $Z_{br}$ may be equivalent impedance at the boundary bus "b" and the reference bus computed using equation 3 given below:

$$Z_{br} = r_{br} + j \; x_{br} \ldots \ldots \ldots (3)$$

The impedance $Z_{a0}$ may be equivalent shunt impedance at the boundary bus "a" and computed using equation 4 given below:

$$Z_{a0} = r_{a0} + j\, x_{a0} \ldots\ldots\ldots (4)$$

The impedance $Z_{b0}$ may be equivalent shunt impedance at the boundary bus "b" and computed using equation 5 given below:

$$Z_{b0} = r_{b0} + j\, x_{b0} \ldots\ldots\ldots (5)$$

In an embodiment, plurality of state variables of the at least one external network m is initially predefined and stored as the external network data 207. In an embodiment, the plurality of state variables of the at least one external network i.e., voltage and angle may be assumed as 1.0 p.u and 0, respectively. In an embodiment, the plurality of state variables of the least one external network may be predicted using one or more techniques, known to person skilled in the art. In an embodiment, topology of the power system may change by inclusion of a new bus or line i.e., impedances at the one or more boundary buses. In that case, it may be necessary to recompute admittance matrix (also referred as $Y_{bus}$ matrix) for formation of impedance matrix (also referred as $Z_{bus}$ matrix). S

Consider an n-bus system exists in an internal network in which voltage-current relations are given in terms of bus impedance matrix. The bus impedance matrix may be as shown in equation 6, given below:

$$\begin{bmatrix} V_1 \\ V_2 \\ \vdots \\ V_n \end{bmatrix} = Z_{int} \begin{bmatrix} I_1 \\ I_2 \\ \vdots \\ I_n \end{bmatrix} \ldots\ldots\ldots (6)$$

where, $V_1, V_2 \ldots\ldots V_n$ are voltages of the internal network and the one or more boundary buses; $I_1, I_2 \ldots\ldots I_n$ are injection current at the internal network and the one or more boundary buses; and
$Z_{int}$ is $Z_{bus}$ matrix of the internal network.

In an embodiment, the simplified network of the power system may be established modifying $Z_{int}$ which is an existing bus impedance matrix.

For stablishing the simplified network, each of the impendences $Z_{ab}$, $Z_{ar}$, $Z_{br}$, $Z_{a0}$ and $Z_{b0}$ may be added to the one or more boundary buses "a" and "b". With the addition of each of the impendences $Z_{ab}$, $Z_{ar}$, $Z_{br}$, $Z_{a0}$ and $Z_{b0}$, voltage current relations of the power system may be modified accordingly. Any sequence of addition of the impendences voltage current relations of the power system may be followed for establishing the simplified network. An exemplary method for addition of the impendences $Z_{ab}$, $Z_{ar}$, $Z_{br}$, $Z_{a0}$ and $Z_{b0}$, to establish the simplified network as in **Figure 4a,** is illustrated in **Figures 4b-4d.**

**Figure 4b** illustrates addition of a new bus to the one or more boundary buses "a" and "b" with impedances $Z_{ar}$ and $Z_{br}$. The new bus at the at least one external network which has not been a part of the internal network 401, is added to an existing bus "a" through a transmission line with the impedance of $Z_{ar}$. The new bus is added to an existing bus "b" through a transmission line with the impedance of $Z_{br}$. Thus, new modified voltage current relations of the power system may be shown as in equation 7, given below:

$$\begin{bmatrix} V_1 \\ V_2 \\ \vdots \\ V_n \\ V_{ref} \end{bmatrix} = \begin{bmatrix} & & & Z_{a1} + Z_{b1} \\ & Z_{int} & & Z_{a2} + Z_{b2} \\ & & & \vdots \\ Z_{a1} + Z_{b1} & Z_{a2} + Z_{b2} & \ldots & Z_a + Z_b \end{bmatrix} \begin{bmatrix} I_1 \\ I_2 \\ \vdots \\ I_n \\ I_{ref} \end{bmatrix} \ldots\ldots\ldots (7)$$

where $V_{ref}$ is predefined reference bus voltage at the at least one external bus; and
$I_{ref}$ *is* reference bus current which is $I_a + I_b$.

In an embodiment, the plurality of predefined state variables of the at least one external network, such as $V_{ref}$, may be user defined for estimating the one or more equivalents. Said plurality of predefined state variables may be assumed minimum and maximum range based on operational constraints of the power system. In an embodiment, the plurality of predefined state variables of the at least one external network may be predicted based on one or more techniques, known to a person skilled in the art. The one or more techniques may be automated techniques. In an embodiment, the plurality of predefined state variables of the at least one external network may be predicted based on correlation obtained for state variables of the internal network 401 and the at least one external network. In an embodiment, the prediction may be an iterative process.

The new modified voltage current relations may be simplified as shown in equation 8, given below:

$$[V_{int\_modified}] = Z_{int\_modified}[I_{int\_modified}] \dots\dots\dots (8)$$

where $V_{int\_modified}$ is modified bus voltage vector including reference bus;
$Z_{int\_modified}$ is modified impedance matrix with additional reference bus; and
$I_{int\_modified}$ is modified current injection vector including reference bus.

**Figure 4c** illustrates addition of new bus with impedance $Z_{ab}$ between boundary buses "a" and "b", along with impedances $Z_{ar}$ and $Z_{br}$. New impedance $Z_{ab}$ is added between two existing boundary buses "a" and "b". Assuming current is injected to the at least one external network from the internal network 401. Current injected into the at least one external network from the boundary bus "a" may be $I_a - I_{ab}$ instead of $I_a$. Similarly, current injected into the at least one external network from the boundary bus "b" may be $I_b - I_{ab}$ instead of $I_b$.

The new voltage current relations in the power system may be provided as shown in equation 9, given below:

$$\begin{bmatrix} V_{int\_modified} \\ 0 \end{bmatrix} = \begin{bmatrix} Z_{int\_modified} & \begin{matrix} Z_{b1} - Z_{a1} \\ Z_{b2} - Z_{a2} \\ \vdots \end{matrix} \\ Z_{b1} - Z_{a1} \quad Z_{b2} - Z_{a2} \quad \dots & Z_{ab\_eq} \end{bmatrix} \begin{bmatrix} I_{int\_modified} \\ I_{ab} \end{bmatrix} \dots\dots\dots (9)$$

where,

$Z_{ab\_eq} = Z_{ab} + Z_{bb} - 2Z_{a\text{-}b} + Z_{aa}$
where, $Z_{aa}$ is equivalent impedance of the internal network at boundary bus "a";
$Z_{bb}$ is equivalent impedance of the internal network at boundary bus "b";
$Z_{a\text{-}b}$ is equivalent mutual impedance of the internal network between boundary buses "a" and "b"; and
$Z_{ab}$ is equivalent mutual impedance of the at least one external network between boundary buses "a" and "b". $Z_{ab}$ may be an unknown value.

Since $I_{ab}$ is unknown, there may be a need to eliminate last row and last column using a reduction technique. In an embodiment, one or more reduction techniques, known to a person skilled in the art, may be implemented for eliminate the last row and the last column. For example, Kron's method may be implemented to eliminate the last row and the last column and obtain final voltage and current relationships of the power system.

**Figure 4d** illustrates addition of shunt impedances $Z_{ao}$ and $Z_{b0}$ to the boundary buses "a" and "b", along with impedances $Z_{ar}$, $Z_{br}$ and $Z_{ab}$. In an embodiment, to simplify the process of adding shunt elements in the impedance matrix, admittance diagonal matrix may be considered.

By adding the impedances $Z_{ar}$, $Z_{br}$, $Z_{ab}$, $Z_{ao}$ and $Z_{b0}$, as illustrated in **Figures 4b-4d,** the simplified network as shown in **Figure 4a,** may be established for the power system. Also, a final impendence may be generated for the power system.

In an embodiment, the addition of the impendence $Z_{ar}$, $Z_{br}$, $Z_{ab}$, $Z_{ao}$ and $Z_{b0}$ as illustrated in **Figures 4b-4d** may be performed to generate admittance matrix. The admittance matrix may further be used for building voltage current relationships. In an embodiment, reference bus of internal network with boundary buses may be used for establishing a simplified network. By which, order of final impedance or admittance matrix may be reduced by 1. In such case, the plurality of state variables of the internal network may be predefined. In an embodiment, sequence of the addition of the impendence $Z_{ar}$, $Z_{br}$, $Z_{ab}$, $Z_{ao}$ and $Z_{b0}$ may not be restricted to the sequences illustrated in **Figures 4b-4d.**

Further, the network parameters estimate module 202 may be configured to estimate the one or more network parameters 209. In an embodiment, the final impedance matrix may be used to estimate the one or more network parameters 209. In an embodiment, the final impedance matrix may be of order (n+1 * n+1). Hence, the final impedance matrix may include n+1 equations to solve with the known voltage and current vector values and to estimate the one or more network parameters 209. The one or more network parameters 209 may be associated with the at least one external network. The one or more network parameters 209 may include any of the plurality of state variable or the plurality of measurements associated with the at least one external network. Any known mathematical method known to a person skilled in the art may be used to estimate the one or more network parameters. In an embodiment, the mathematical method may be any optimization technique to solve few unknown variables with large number of equations.

Further, the tuning module 203 may be configured to perform tuning of the one or more network parameters 209. Requirement of the tuning process, for estimating the one or more equivalent parameters 213, may be identified based on mismatch associated with at least one of power flow and state variables in the one or more boundary buses. A state estimation of the power system using the one or more network parameters 209 may be performed. In an embodiment, the estimated state may be stored as the state estimation data 210 in the memory 108. The residual 211 associated with the state estimation of the power system may be determined and compared with the threshold value 212. The residual 211 may be an error associated with plurality of state variables of the internal network. One or more techniques, known to a person skilled in the art, may be implemented for determining the residual 211. In an embodiment, the threshold value 212 may be defined by a user. For example, the threshold value 212 may be 0.001 or 0.01 or any precision required by the user.

Further, when the residual 211 is determined to be greater than the threshold value 212, the one or more network parameters 209 are optimized for further state estimation of the power system. In an embodiment, optimizing the one or more network parameters 209 may be performed to reduce the residual 211. By which the mismatch may also be minimized. In an embodiment, by optimizing the one or more network parameters 209, values of the one or more network parameters 209 may be varied to minimize the residual 211.

In an embodiment, optimizing the one or more network parameters 209 may be performed based on sensitivity factors associated with the one or more network parameters 209 of the at least one external network. In an embodiment, the sensitivity factors may be calculated with respect to power flows in the one or more boundary buses. Further, the optimization technique may be used to minimize the error at tie-line or power flow of the internal network. In an embodiment, Jacobian matrix may be framed with respect to measurements and reactance's at the at least one external network using equations 10 and 11, defined below.

$$P_k = \sum_{j=1}^{no.of\ tie-lines} |V_k||V_j|(B_{kj}\sin(\theta_k - \theta_{ki})) \dots\dots\dots (10)$$

$$Q_k = \sum_{j=1}^{no.of\ tie-lines} |V_k||V_j|(-B_{kj}\cos(\theta_k - \theta_{ki})) \dots\dots\dots (11)$$

In an embodiment, the number of tie-lines used in the equations 10 and 1, may be can be total lines in the internal network including the one or more boundary buses and number of lines at the at least one external network. The equations 10 and 11 are power flow equations which are simplified based on the assumption that reactance is more predominant than resistance. In an embodiment, the power flow equations may be incorporated with resistances for better accuracy levels.

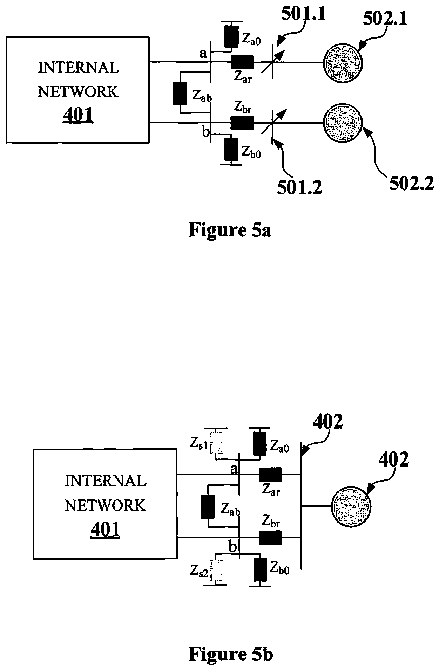

In an embodiment, optimizing the one or more network parameters 209 is performed by splitting the bus for the one or more boundary buses. **Figure 5a** illustrates splitting of the bus in the power system. Initially the reference bus may be connected to the one or more boundary buses with equivalent line impedances. However, for tuning process, the reference bus may be split to buses 502.1 and 502.2. The optimization method is used to reduce the mismatch of the power flows at the tie-line or the internal network 401. In an embodiment, assumed state variables 501.1 and 501.2 i.e., voltage and angle may be 1.0 p.u and 0, respectively. Further, said state variables are finetuned with a step size at each external network split buses by maintaining physical constraints as state variables like minimum and maximum operation constraints. Based on the observed changes, the one or more network parameters 209 may be optimized. If external network split reference buses 502.1 and 502.2 are not observed with any change in specified PV, AV, PQ, AQ variables, the reference bus type may be replaced based on the constant variables. In an embodiment, based on top two minimum change in the residual 211, the type of bus may be defined at the at least one external network. When the reference bus is PV bus, the specified real power and voltage are constant at the external network split buses 502.1 and 502.2. When the reference bus is AV bus, specified angle and voltage are constant at the external network split buses 502.1 and 502.2. When the reference bus is PO bus, specified real power and reactive power are constant at the external network split buses 502.1 and 502.2. When the reference bus is AO, specified angle and reactive power are constant at the external network split buses 502.1 and 502.2. In an embodiment, the various combinations of bus types at the external network split buses 502.1 and 502.2 may be possible for each scenario.

In an embodiment, optimizing the one or more network parameters 209 may be performed by injecting one or more shunts in the simplified network. **Figure 5b** illustrates addition of shunt impedances $Z_{s1}$ and $Z_{s2}$. In an embodiment, small mismatches in the tie-lines may be adjusted using the shunt impedances $Z_{s1}$ and $Z_{s2}$, since threshold of the residual may allow some deviation at the tie-line.

In an embodiment, at least one of optimizing based on the sensitivity factors, optimizing by splitting the bus for the one or more boundary buses, and optimizing by injecting one or more shunts, may be performed for tuning. One or more combinations of said optimizing methods may be implemented in the estimation system 101, for tuning the one or more network parameters. In an embodiment, the optimizing method may be selected by a user.

The tuning module 203 may perform tuning until the residual 211 is determined to be lesser than the threshold value 212. Upon tuning and optimizing, the equivalent parameters provide module 204 may be configured to provide the one or more network parameters 209, which are optimized, as the one or more equivalent parameters 213 for the at least one external network.

In an embodiment, the one or more equivalent parameters 213 may be provided to one or more real time operational applications to perform or prepare for futuristic events associated with the power system. Also, the one or more real time operational applications may be configured to determine counter measure actions for the contingencies in the power system, using the one or more equivalent parameters. In an embodiment, the one or more equivalent parameters may be provided to any module configured to provide one or more facilities to the power system.

The other data 214 may store data, including temporary data and temporary files, generated by modules for performing the various functions of the estimation system 101. The one or more modules 109 may also include other modules 205 to perform various miscellaneous functionalities of the estimation system 101. It will be appreciated that such modules may be represented as a single module or a combination of different modules.

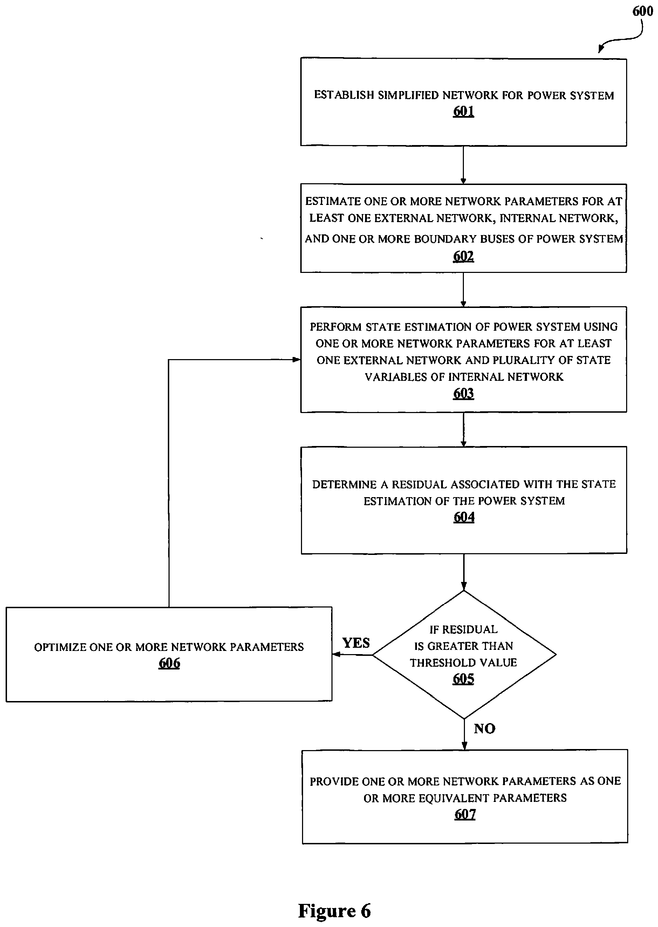

**Figure 6a** illustrates a flowchart showing an exemplary method to estimate one or more equivalent parameters for the at least one external network, in accordance with some embodiments of present disclosure.

At block 601, the simplified network establish module 201 of the estimation system 101 may be configured to establish the simplified network for the power system 102. The simplified network may be established based on the plurality of state variables of the internal network 104. The at least one external network 105 may be represented as the bus with the plurality of predefined state variables for the at least one external network 105, to establish the simplified network. In an embodiment, the simplified network establish module 201 may be configured to determine the one or more boundary buses and corresponding flow of the real power and the reactive power flow associated with the internal network 104, based on the plurality of state variables of the internal network 104. Further, the simplified network establish module 201 may be configured to extend the internal network 104 along with the one or more boundary buses using the bus through the one or more impendences.

At block 602, the network parameters estimate module 202 of the estimation system 101 may be configured to estimate the one or more network parameters 209 for the at least one external network 105. The one or more network parameters 209 may be estimated based on the simplified network and the plurality of predefined state variables, using the optimization technique. In an embodiment, any optimization technique, known to a person skilled in the art, may be used for estimating the one or more network parameters 209.

At block 603, the tuning module 203 of the estimation system 101 may be configured to perform the state estimation of the power system 102 using the one or more network parameters 209. The tuning may be performed based on the state variables and the measurements of the internal network and the one or more boundary buses. One or more techniques, known to a person skilled in the art, may be implemented for performing the state estimation.

At block 604, the tuning module 203 of the estimation system 101 may be configured to determine the residual 211 associated with the state estimation of the power system 102. The determined residual 211 may be compared with the threshold value 212.

At block 605, the tuning module 203 of the estimation system 101 may be configured to check if the residual 211 is greater than the threshold value 212. Step in block 606 may be performed when the residual 211 is greater than the threshold value 212. Step in block 607 may be performed when the residual 211 is lesser than the threshold value 212.

At block 606, when the residual 211 is greater than the threshold value 212, the tuning module 203 of the estimation system 101 may be configured to optimize the one or more network parameters 209. Upon optimizing, the optimized one or more network parameters are used for further state estimation. The steps of blocks 603, 404, 605 and 606 are performed until the residual is determined to be lesser than the threshold value 212.

At block 607, when the residual 211 is lesser than the threshold value 212, the equivalent parameter provide module 204 of the estimation system 101 may be configured to provide the one or more network parameters 209 as the one or more equivalent parameters 213 of the at least one external network 105.

As illustrated in **Figure 6,** the method 600 may include one or more blocks for executing processes in the estimation system 101. The method 600 may be described in the general context of computer executable instructions. Generally, computer executable instructions can include routines, programs, objects, components, data structures, procedures, modules, and functions, which perform particular functions or implement particular abstract data types.

The order in which the method 600 are described may not intended to be construed as a limitation, and any number of the described method blocks can be combined in any order to implement the method. Additionally, individual blocks may be deleted from the methods without departing from the scope of the subject matter described herein. Furthermore, the method can be implemented in any suitable hardware, software, firmware, or combination thereof.

Computing System

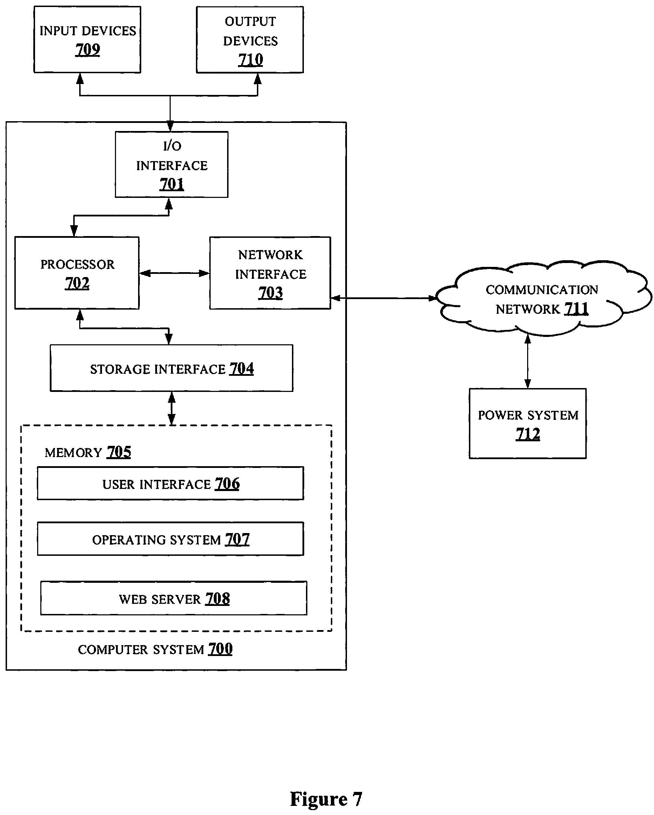

**Figure 7** illustrates a block diagram of an exemplary computer system 700 for implementing embodiments consistent with the present disclosure. In an embodiment, the computer system 700 is used to implement the estimation system 101. The computer system 700 may include a central processing unit ("CPU" or "processor") 702. The processor 702 may include at least one data processor for executing processes in Virtual Storage Area Network. The processor 702 may include specialized processing units such as, integrated system (bus) controllers, memory management control units, floating point units, graphics processing units, digital signal processing units, etc.

The processor 702 may be disposed in communication with one or more input/output (I/O) devices 709 and 710 via I/O interface 701. The I/O interface 701 may employ communication protocols/methods such as, without limitation, audio, analog, digital, monaural, RCA, stereo, IEEE-1394, serial bus, universal serial bus (USB), infrared, PS/2, BNC, coaxial, component, composite, digital visual interface (DVI), high-definition multimedia interface (HDMI), RF antennas, S-Video, VGA, IEEE 802.n /b/g/n/x, Bluetooth, cellular (e.g., code-division multiple access (CDMA), high-speed packet access (HSPA+), global system for mobile communications (GSM), long-term evolution (LTE), WiMax, or the like), etc.

Using the I/O interface 701, the computer system 700 may communicate with one or more I/O devices 709 and 710. For example, the input devices 709 may be an antenna, keyboard, mouse, joystick, (infrared) remote control, camera, card reader, fax machine, dongle, biometric reader, microphone, touch screen, touchpad, trackball, stylus, scanner, storage device, transceiver, video device/source, etc. The output devices 710 may be a printer, fax machine, video display (e.g., cathode ray tube (CRT), liquid crystal display (LCD), light-emitting diode (LED), plasma, Plasma display panel (PDP), Organic light-emitting diode display (OLED) or the like), audio speaker, etc.

In some embodiments, the computer system 700 may consist of the estimation system 101. The processor 702 may be disposed in communication with the communication network 711 via a network interface 703. The network interface 703 may communicate with the communication network 711. The network interface 703 may employ connection protocols including, without limitation, direct connect, Ethernet (e.g., twisted pair 10/100/1000 Base T), transmission control protocol/internet protocol (TCP/IP), token ring, IEEE 802.11a/b/g/n/x, etc. The communication network 711 may include, without limitation, a direct interconnection, local area network (LAN), wide area network (WAN), wireless network (e.g., using Wireless Application Protocol), the Internet, etc. Using the network interface 703 and the communication network 711, the computer system 700 may communicate with power system 712 for estimating the one or more equivalent parameters. The network interface 703 may employ connection protocols include, but not limited to, direct connect, Ethernet (e.g., twisted pair 10/100/1000 Base T), transmission control protocol/internet protocol (TCP/IP), token ring, IEEE 802.11a/b/g/n/x, etc.

The communication network 711 includes, but is not limited to, a direct interconnection, an e-commerce network, a peer to peer (P2P) network, local area network (LAN), wide area network (WAN), wireless network (e.g., using Wireless Application Protocol), the Internet, Wi-Fi, and such. The first network and the second network may either be a dedicated network or a shared network, which represents an association of the different types of networks that use a variety of protocols, for example, Hypertext Transfer Protocol (HTTP), Transmission Control Protocol/Internet Protocol (TCP/IP), Wireless Application Protocol (WAP), etc., to communicate with each other. Further, the first network and the second network may include a variety of network devices, including routers, bridges, servers, computing devices, storage devices, etc.

In some embodiments, the processor 702 may be disposed in communication with a memory 705 (e.g., RAM, ROM, etc. not shown in **Figure 7**) via a storage interface 704. The storage interface 704 may connect to memory 705 including, without limitation, memory drives, removable disc drives, etc., employing connection protocols such as, serial advanced technology attachment (SATA), Integrated Drive Electronics (IDE), IEEE-1394, Universal Serial Bus (USB), fibre channel, Small Computer Systems Interface (SCSI), etc. The memory drives may further include a drum, magnetic disc drive, magneto-optical drive, optical drive, Redundant Array of Independent Discs (RAID), solid-state memory devices, solid-state drives, etc.

The memory 705 may store a collection of program or database components, including, without limitation, user interface 706, an operating system 707 etc. In some embodiments, computer system 700 may store user/application data 706, such as, the data, variables, records, etc., as described in this disclosure. Such databases may be implemented as fault-tolerant, relational, scalable, secure databases such as Oracle ® or Sybase®.

The operating system 707 may facilitate resource management and operation of the computer system 700. Examples of operating systems include, without limitation, APPLE MACINTOSH® OS X, UNIX®, UNIX-like system distributions (E.G., BERKELEY SOFTWARE DISTRIBUTION™ (BSD), FREEBSD™, NETBSD™, OPENBSD™, etc.), LINUX DISTRIBUTIONS™ (E.G., RED HAT™, UBUNTU™, KUBUNTU™, etc.), IBM™ OS/2, MICROSOFT™ WINDOWS™ (XP™, VISTA™/7/8, 10 etc.), APPLE® IOS™, GOOGLE® ANDROID™, BLACKBERRY® OS, or the like.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include Random Access Memory (RAM), Read-Only Memory (ROM), volatile memory, non-volatile memory, hard drives, CD ROMs, DVDs, flash drives, disks, and any other known physical storage media.

## Advantages

An embodiment of the present disclosure provisions enhancement in accuracy of through power flows at external network for outages in internal network, even without any information or data of external networks connected to internal networks.

An embodiment of the present disclosure, by estimating equivalent parameters as proposed, counter measure actions for futuristic events based on security assessment for each state estimation time period may be computed in advance.

The described operations may be implemented as a method, system or article of manufacture using standard programming and/or engineering techniques to produce software, firmware, hardware, or any combination thereof. The described operations may be implemented as code maintained in a "non-transitory computer readable medium", where a processor may read and execute the code from the computer readable medium. The processor is at least one of a microprocessor and a processor capable of processing and executing the queries. A non-transitory computer readable medium may include media such as magnetic storage medium (e.g., hard disk drives, floppy disks, tape, etc.), optical storage (CD-ROMs, DVDs, optical disks, etc.), volatile and non-volatile memory devices (e.g., EEPROMs, ROMs, PROMs, RAMs, DRAMs, SRAMs, Flash Memory, firmware, programmable logic, etc.), etc. Further, non-transitory computer-readable media may include all computer-readable media except for a transitory. The code implementing the described operations may further be implemented in hardware logic (e.g., an integrated circuit chip, Programmable Gate Array (PGA), Application Specific Integrated Circuit (ASIC), etc.).

An "article of manufacture" includes non-transitory computer readable medium, and /or hardware logic, in which code may be implemented. A device in which the code implementing the described embodiments of operations is encoded may include a computer readable medium or hardware logic. Of course, those skilled in the art will recognize that many modifications may be made to this configuration without departing from the scope of the invention, and that the article of manufacture may include suitable information bearing medium known in the art. The terms "an embodiment", "embodiment", "embodiments", "the embodiment", "the embodiments", "one or more embodiments", "some embodiments", and "one embodiment" mean "one or more (but not all) embodiments of the invention(s)" unless expressly specified otherwise.

The terms "including", "comprising", "having" and variations thereof mean "including but not limited to", unless expressly specified otherwise.

The enumerated listing of items does not imply that any or all of the items are mutually exclusive, unless expressly specified otherwise.

The terms "a", "an" and "the" mean "one or more", unless expressly specified otherwise.

A description of an embodiment with several components in communication with each other does not imply that all such components are required. On the contrary a variety of optional components are described to illustrate the wide variety of possible embodiments of the invention.

When a single device or article is described herein, it will be readily apparent that more than one device/article (whether or not they cooperate) may be used in place of a single device/article. Similarly, where more than one device or article is described herein (whether or not they cooperate), it will be readily apparent that a single device/article may be used in place of the more than one device or article or a different number of devices/articles may be used instead of the shown number of devices or programs. The functionality and/or the features of a device may be alternatively embodied by one or more other devices which are not explicitly described as having such functionality/features. Thus, other embodiments of the invention need not include the device itself.

The illustrated operations of **Figure 6** show certain events occurring in a certain order. In alternative embodiments, certain operations may be performed in a different order, modified, or removed. Moreover, steps may be added to the above described logic and still conform to the described embodiments. Further, operations described herein may occur sequentially or certain operations may be processed in parallel. Yet further, operations may be performed by a single processing unit or by distributed processing units.

Finally, the language used in the specification has been principally selected for readability and instructional purposes, and it may not have been selected to delineate or circumscribe the inventive subject matter. It is therefore intended that the scope of the invention be limited not by this detailed description, but rather by any claims that issue on an application based here on. Accordingly, the disclosure of the embodiments of the invention is intended to be illustrative, but not limiting, of the scope of the invention, which is set forth in the following claims.

**Referral numerals:**

| Reference Number | Description |
|---|---|
| 100 | Environment |
| 101 | Estimation system |
| 102 | Power system |
| 103 | Communication network |
| 104 | Internal network |
| 105 | External network |
| 106 | Processor |
| 107 | I/O interface |
| 108 | Memory |
| 109 | Modules |
| 110 | Data |
| 201 | Simplified network establish module |
| 202 | Network parameters estimate module |
| 203 | Tuning module |
| 204 | Equivalent parameters provide module |
| 205 | Other modules |
| 206 | Internal network data |
| 207 | External network data |
| 208 | Boundary bus data |
| 209 | Network parameters |
| 210 | State estimation data |
| 211 | Residual data |
| 212 | threshold value |
| 213 | Equivalent parameters |
| 214 | Other data |
| 301 | Internal network |
| 302.1 | First external network |
| 302.2 | Second external network |
| 302.3 | Third external network |
| 303 | Simplified network |
| 401 | Internal network |
| 402 | Bus |
| 403 | Reference node |
| 501.1 and 501.2 | Split reference buses |
| 502.1 and 502.2 | Predefined state variables of external network |
| 700 | Computer System |
| 701 | I/O Interface |

(continued)

| Reference Number | Description |
|---|---|
| 702 | Processor |
| 703 | Network Interface |
| 704 | Storage Interface |
| 705 | Memory |
| 706 | User Interface |
| 707 | Operating System |
| 708 | Web Server |
| 709 | Input Devices |
| 710 | Output Devices |
| 711 | Communication Network |
| 712 | Power system |

**Claims**

1. A method to estimate one or more equivalent parameters (213) for at least one external network (105) associated with an internal network (104. 301, 401) in a power system (102), wherein the method comprising:

   establishing, by an estimation system (101), a simplified network (303) for a power system (102) comprising an internal network (104. 301, 401) and at least one external network (105), based on at least one of state variables and measurements of the internal network (104. 301, 401) and one or more boundary buses of the power system (102), wherein the at least one external network (105) is represented as a bus with plurality of predefined state variables (502.1, 502.2) for the at least one external network (105), to establish the simplified network (303);
   estimating, by the estimation system (101), one or more network parameters (209), such as power flow or state variables in the one or more boundary buses, for the at least one external network (105), based on the simplified network (303) and the plurality of predefined state variables (502.1, 502.2), using an optimization technique;
   performing, by the estimation system (101), tuning of the one or more network parameters (209) with respect to the state variables and the measurements of the internal network (104. 301, 401) and the one or more boundary buses, by performing the steps of:

      performing, by the estimation system (101), a state estimation of the power system (102) using the one or more network parameters (209);
      determining, by the estimation system (101), a residual associated with the state estimation of the power system (102), wherein the residual is compared with a threshold value (212); and
      optimizing, by the estimation system (101), the one or more network parameters (209) for performing further state estimation of the power system (102), when the residual is determined to be greater than the threshold value (212), wherein the tuning is performing until the residual is determined to be lesser than the threshold value (212); and

   providing, by the estimation system (101), the one or more network parameters (209) as one or more equivalent parameters (213) for the at least one external network (105),
   **characterized in that** the optimizing of the one or more network parameters (209) is performed by:
   splitting the bus for the one or more boundary buses; and
   varying values of the one or more network parameters (209) for each of the one or more boundary buses, to minimize residuals associated with at least one of real power, voltage, angle, reactive power of the internal network (104. 301, 401) and the one or more boundary buses.

2. The method as claimed in claim 1, wherein establishing the simplified network (303) for the power system (102) comprises:

determining the one or more boundary buses and corresponding flow of real power and reactive power flow associated with the internal network (104. 301, 401), based on the state variables of the internal network (104. 301, 401); and
extending the internal network (104. 301, 401) along with the one or more boundary buses using the bus through one or more impendences.

3. The method as claimed in claim 1, wherein optimizing the one or more network parameters (209) is performed to reduce a mismatch associated with at least one of power flow and state variables in the one or more boundary buses.

4. The method as claimed in claim 1, wherein optimizing the one or more network parameters (209) is performed based on sensitivity factors associated with the one or more network parameters (209) of the external network (105).

5. The method as claimed in claim 1, wherein the optimizing the one or more network parameters (209) is performed by:

injecting one or more shunt impedances in the simplified network (303); and
adjusting values of the one or more shunt impedances to optimize the one or more network parameters (209).

6. An estimation system (101) to estimate one or more equivalent parameters (213) for at least one external network (105) associated with an internal network (104. 301, 401) in a power system (102), said estimation system (101) comprises:

a processor (106, 702); and
a memory (108, 705) communicatively coupled to the processor (106, 702), wherein the memory (108, 705) configured to store processor-executable instructions, which, on execution, is configured to cause the processor (106, 702) to:

establish a simplified network (303) for a power system (102) comprising an internal network (104. 301, 401) and at least one external network (105), based on at least one of state variables and measurements of the internal network (104. 301, 401) and one or more boundary buses of the power system (102), wherein the at least one external network (105) is represented as a bus with plurality of predefined state variables (502.1, 502.2) for the at least one external network (105), to establish the simplified network (303);
estimate one or more network parameters (209), such as power flow or state variables in the one or more boundary buses, for the at least one external network (105), based on the simplified network (303) and the plurality of predefined state variables (502.1, 502.2), using an optimization technique;
perform tuning of the one or more network parameters (209) with respect to the state variables and the measurements of the internal network (104. 301, 401) and the one or more boundary buses, by performing the steps of:

performing a state estimation of the power system (102) using the one or more network parameters (209);
determining a residual associated with the state estimation of the power system (102), wherein the residual is compared with a threshold value (212); and
optimizing the one or more network parameters (209) for performing further state estimation of the power system (102), when the residual is determined to be greater than the threshold value (212), wherein the tuning is performing until the residual is determined to be lesser than the threshold value (212); and

provide the one or more network parameters (209) as one or more equivalent parameters (213) for the at least one external network (105),
**characterized in that** the optimizing of the one or more network parameters (209) is performed by:
splitting the bus for the one or more boundary buses; and
varying values of the one or more network parameters (209) for each of the one or more boundary buses, to minimize residuals associated with at least one of real power, voltage, angle, reactive power of the internal network (104. 301, 401) and the one or more boundary buses.

7. The estimation system (101) as claimed in claim 6, wherein the simplified network (303) for the power system (102) is established by:

determining the one or more boundary buses and corresponding flow of real power and reactive power flow associated with the internal network (104. 301, 401), based on the plurality of state variables of the internal network (104. 301, 401); and

extending the internal network (104. 301, 401) along with the one or more boundary buses using the bus through one or more impendences.

8. The estimation system (101) as claimed in claim 7, wherein optimizing the one or more network parameters (209) is performed to reduce a mismatch associated with at least one of power flow and state variables in the one or more boundary buses.

9. The estimation system (101) as claimed in claim 7, wherein optimizing the one or more network parameters (209) is performed based on sensitivity factors associated with the one or more network parameters (209) of the external network (105).

10. The estimation system (101) as claimed in claim 7, wherein the optimizing the one or more network parameters (209) is performed by:

injecting one or more shunt impedances in the simplified network (303); and

adjusting values of the one or more shunt impedances to optimize the one or more network parameters (209).

**Patentansprüche**

1. Verfahren zum Schätzen eines oder mehrerer äquivalenter Parameter (213) für mindestens ein externes Netz (105), das einem internen Netz (104, 301, 401) in einem Stromversorgungssystem (102) zugeordnet ist, wobei das Verfahren Folgendes umfasst:

Einrichten durch ein Schätzsystem (101) eines vereinfachten Netzes (303) für ein Stromversorgungssystem (102), das ein internes Netz (104. 301, 401) und mindestens ein externes Netz (105) umfasst, anhand von Zustandsvariablen und/oder Messungen des internen Netzes (104. 301, 401) und eines oder mehrerer Grenzbusse des Stromversorgungssystems (102), wobei das mindestens eine externe Netz (105) als ein Bus mit mehreren im Voraus definierten Zustandsvariablen (502.1, 502.2) für das mindestens eine externe Netz (105) repräsentiert wird, um das vereinfachte Netz (303) einzurichten;
Schätzen durch das Schätzsystem (101) eines oder mehrerer Netzparameter (209), wie etwa einen Leistungsfluss oder Zustandsvariablen in dem einen oder den mehreren Grenzbussen, für das mindestens eine externe Netz (105) anhand des vereinfachten Netzes (303) und der mehreren im Voraus definierten Zustandsvariablen (502.1, 502.2) unter Verwendung einer Optimierungstechnik;
Ausführen durch das Schätzsystem (101) eines Abstimmens des einen oder der mehreren Netzparameter (209) in Bezug auf die Zustandsvariablen und die Messungen des internen Netzes (104. 301, 401) und des einen oder der mehreren Grenzbusse, durch Ausführen der folgenden Schritte:

Ausführen durch das Schätzsystem (101) einer Zustandsschätzung des Stromversorgungssystems (102) unter Verwendung des einen oder der mehreren Netzparameter (209);
Bestimmen durch das Schätzsystem (101) eines Restwerts, der der Zustandsschätzung des Stromversorgungssystems (102) zugeordnet ist, wobei der Restwert mit einem Schwellenwert (212) verglichen wird; und
Optimieren durch das Schätzsystem (101) des einen oder der mehreren Netzparameter (209) für das Ausführen einer weiteren Zustandsschätzung des Stromversorgungssystems (102), wenn bestimmt wird, dass der Restwert größer als der Schwellenwert (212) ist, wobei das Abstimmen ein Ausführen, bis bestimmt wird, dass der Restwert kleiner ist als der Schwellenwert (212), umfasst; und
Liefern durch das Schätzsystem (101) des einen oder der mehreren Netzparameter (209) als einen oder mehrere äquivalente Parameter (213) für das mindestens eine externe Netz (105),

**dadurch gekennzeichnet, dass** die Optimierung des einen oder der mehreren Netzparameter (209) ausgeführt wird durch:

Aufteilen des Busses für den einen oder die mehreren Grenzbusse; und
Variieren von Werten des einen oder der mehreren Netzparameter (209) für jeden des einen oder der mehreren Grenzbusse, um Restwerte, die einer Wirkleistung und/oder einer Spannung und/oder einem Winkel und/oder einer Blindleistung des internen Netzes (104. 301, 401) und dem einen oder den mehreren Grenzbussen zugeordnet sind, zu minimieren.

2. Verfahren nach Anspruch 1, wobei das Einrichten des vereinfachten Netzes (303) für das Stromversorgungssystem (102) umfasst:

Bestimmen des einen oder der mehreren Grenzbusse und eines entsprechenden Flusses von Wirkleistung und eines Flusses von Blindleistung, die dem internen Netz (104. 301, 401) zugeordnet sind, anhand der Zustandsvariablen des internen Netzes (104. 301, 401); und
Erweitern des internen Netzes (104. 301, 401) zusammen mit dem einen oder den mehreren Grenzbussen unter Verwendung des Busses durch eine oder mehrere Impedanzen.

3. Verfahren nach Anspruch 1, wobei das Optimieren des einen oder der mehreren Netzparameter (209) ausgeführt wird, um eine Fehlanpassung, die einem Leistungsfluss und/oder Zustandsvariablen in dem einen oder den mehreren Grenzbussen zugeordnet ist, zu verringern.

4. Verfahren nach Anspruch 1, wobei das Optimieren des einen oder der mehreren Netzparameter (209) anhand von Empfindlichkeitsfaktoren, die dem einen oder den mehreren Netzparametern (209) des externen Netzes (105) zugeordnet sind, ausgeführt wird.

5. Verfahren nach Anspruch 1, wobei das Optimieren des einen oder der mehreren Netzparameter (209) ausgeführt wird, durch:

Einspeisen einer oder mehrerer Nebenschlussimpedanzen in das vereinfachte Netz (303); und
Anpassen von Werten der einen oder der mehreren Nebenschlussimpedanzen, um den einen oder die mehreren Netzparameter (209) zu optimieren.

6. Schätzsystem (101), um einen oder mehrere äquivalente Parameter (213) für mindestens ein externes Netz (105), das einem internen Netz (104. 301, 401) in einem Stromversorgungssystem (102) zugeordnet ist, zu schätzen, wobei das Schätzsystem (101) umfasst:

einen Prozessor (106, 702); und
einen Speicher (108, 705), der an den Prozessor (106, 702) kommunikativ gekoppelt ist, wobei der Speicher (108, 705) konfiguriert ist, prozessorausführbare Anweisungen zu speichern, die bei Ausführung konfiguriert sind, zu bewirken, dass der Prozessor (106, 702):

ein vereinfachtes Netz (303) für ein Stromversorgungssystem (102), das ein internes Netz (104. 301, 401) und mindestens ein externes Netz (105) umfasst, anhand von Zustandsvariablen und/oder Messungen des internen Netzes (104. 301, 401) und eines oder mehrerer Grenzbusse des Stromversorgungssystems (102) einrichtet, wobei das mindestens eine externe Netz (105) als ein Bus mit mehreren im Voraus definierten Zustandsvariablen (502.1, 502.2) für das mindestens eine externe Netz (105) repräsentiert wird, um das vereinfachte Netz (303) einzurichten;
einen oder mehrere Netzparameter (209), wie etwa einen Leistungsfluss oder Zustandsvariablen in dem einen oder den mehreren Grenzbussen, für das mindestens eine externe Netz (105) anhand des vereinfachten Netzes (303) und der mehreren im Voraus definierten Zustandsvariablen (502.1, 502.2) unter Verwendung einer Optimierungstechnik schätzt;
ein Abstimmen des einen oder der mehreren Netzparameter (209) in Bezug auf die Zustandsvariablen und die Messungen des internen Netzes (104. 301, 401) und den einen oder die mehreren Grenzbusse ausführt durch Ausführen der Schritte:

Ausführen einer Zustandsschätzung des Stromversorgungssystems (102) unter Verwendung des einen oder der mehreren Netzparameter (209);
Bestimmen eines Restwerts, der der Zustandsschätzung des Stromversorgungssystems (102) zugeordnet ist, wobei der Restwert mit einem Schwellenwert (212) verglichen wird; und
Optimieren des einen oder der mehreren Netzparameter (209) zum Ausführen einer weiteren Zustandsschätzung des Stromversorgungssystems (102), wenn bestimmt wird, dass der Restwert größer als der Schwellenwert (212) ist, wobei das Abstimmen ein Ausführen, bis bestimmt wird, dass der Restwert kleiner als der Schwellenwert (212) ist, ist; und

Liefern des einen oder der mehreren Netzparameter (209) als einen oder mehrere äquivalente Parameter (213) für das mindestens eine externe Netz (105),

**dadurch gekennzeichnet, dass** die Optimierung des einen oder der mehreren Netzparameter (209) ausgeführt wird durch:

Aufteilen des Busses für den einen oder die mehreren Grenzbusse; und
Variieren von Werten des einen oder der mehreren Netzparameter (209) für jeden des einen oder der mehreren Grenzbusse, um Restwerte, die einer Wirkleistung und/oder einer Spannung und/oder einem Winkel und/oder einer Blindleistung des internen Netzes (104. 301, 401) und dem einen oder den mehreren Grenzbussen zugeordnet sind, zu minimieren.

7. Schätzsystem (101) nach Anspruch 6, wobei das vereinfachte Netz (303) für das Stromversorgungssystem (102) eingerichtet wird durch:

Bestimmen des einen oder der mehreren Grenzbusse und eines entsprechenden Flusses von Wirkleistung und eines Flusses von Blindleistung, die dem internen Netz (104. 301, 401) zugeordnet sind, anhand der mehreren Zustandsvariablen des internen Netzes (104.301, 401); und
Erweitern des internen Netzes (104. 301, 401) zusammen mit dem einen oder den mehreren Grenzbussen unter Verwendung des Busses durch eine oder mehrere Impedanzen.

8. Schätzsystem (101) nach Anspruch 7, wobei das Optimieren des einen oder der mehreren Netzparameter (209) ausgeführt wird, um eine Fehlanpassung, die einem Leistungsfluss und/oder Zustandsvariablen in dem einen oder den mehreren Grenzbussen zugeordnet ist, zu verringern.

9. Schätzsystem (101) nach Anspruch 7, wobei das Optimieren des einen oder der mehreren Netzparameter (209) anhand von Empfindlichkeitsfaktoren, die dem einen oder den mehreren Netzparametern (209) des externen Netzes (105) zugeordnet sind, ausgeführt wird.

10. Schätzsystem (101) nach Anspruch 7, wobei das Optimieren des einen oder der mehreren Netzparameter (209) ausgeführt wird durch:

Einspeisen einer oder mehrerer Nebenschlussimpedanzen in das vereinfachte Netz (303); und
Anpassen von Werten der einen oder der mehreren Nebenschlussimpedanzen, um den einen oder die mehreren Netzparameter (209) zu optimieren.


**Revendications**

1. Procédé pour estimer un ou plusieurs paramètres équivalents (213) pour au moins un réseau externe (105) associé à un réseau interne (104. 301, 401) dans un système électrique (102), le procédé comprenant les étapes consistant à :

établir, par un système d'estimation (101), un réseau simplifié (303) pour un système électrique (102) comprenant un réseau interne (104. 301, 401) et au moins un réseau externe (105), sur la base d'au moins un élément parmi des variables d'état et des mesures du réseau interne (104. 301, 401) et d'un ou plusieurs bus frontières du système électrique (102), ledit au moins un réseau externe (105) étant représenté sous la forme d'un bus avec une pluralité de variables d'état prédéfinies (502.1, 502.2) pour ledit au moins un réseau externe (105), pour établir le réseau simplifié (303) ;
estimer, par le système d'estimation (101), un ou plusieurs paramètres de réseau (209), tels qu'un flux de puissance ou des variables d'état dans lesdits un ou plusieurs bus frontières, pour ledit au moins un réseau externe (105), sur la base du réseau simplifié (303) et de la pluralité de variables d'état prédéfinies (502.1, 502.2), en utilisant une technique d'optimisation ;
effectuer, par le système d'estimation (101), l'accord desdits un ou plusieurs paramètres de réseau (209) en ce qui concerne les variables d'état et les mesures du réseau interne (104. 301, 401) et desdits un ou plusieurs bus frontières, en effectuant les étapes consistant à :

effectuer, par le système d'estimation (101), une estimation d'état du système électrique (102) en utilisant lesdits un ou plusieurs paramètres de réseau (209) ;

déterminer, par le système d'estimation (101), un résidu associé à l'estimation d'état du système électrique (102), le résidu étant comparé avec une valeur seuil (212) ; et

optimiser, par le système d'estimation (101), lesdits un ou plusieurs paramètres de réseau (209) pour effectuer une nouvelle estimation d'état du système électrique (102) lorsque le résidu est déterminé comme étant supérieur à la valeur seuil (212), l'accord étant effectué jusqu'à ce que le résidu soit déterminé comme étant inférieur à la valeur seuil (212) ; et

fournir, par le système d'estimation (101), lesdits un ou plusieurs paramètres de réseau (209) sous la forme d'un ou plusieurs paramètres équivalents (213) pour ledit au moins un réseau externe (105), **caractérisé en ce que** l'optimisation desdits un ou plusieurs paramètres de réseau (209) est effectuée en :

divisant le bus pour lesdits un ou plusieurs bus frontières ; et

faisant varier les valeurs desdits un ou plusieurs paramètres de réseau (209) pour chacun desdits un ou plusieurs bus frontières, pour minimiser les résidus associés à au moins une valeur parmi la puissance réelle, la tension, l'angle et la puissance réactive du réseau interne (104. 301, 401) et desdits un ou plusieurs bus frontières.

2. Procédé selon la revendication 1, dans lequel l'étape consistant à établir le réseau simplifié (303) pour le système électrique (102) consiste à :

déterminer lesdits un ou plusieurs bus frontières et un flux correspondant de puissance réelle et un flux de puissance réactive associés au réseau interne (104. 301, 401), sur la base des variables d'état du réseau interne (104. 301, 401) ; et

étendre le réseau interne (104. 301, 401) ainsi que lesdits un ou plusieurs bus frontières en utilisant le bus à travers une ou plusieurs impédances.

3. Procédé selon la revendication 1, dans lequel l'étape consistant à optimiser lesdits un ou plusieurs paramètres de réseau (209) est effectuée pour réduire une désadaptation associée à au moins un élément parmi un flux de puissance et des variables d'état dans lesdits un ou plusieurs bus frontières.

4. Procédé selon la revendication 1, dans lequel l'étape consistant à optimiser lesdits un ou plusieurs paramètres de réseau (209) est effectuée sur la base de facteurs de sensibilité associés auxdits un ou plusieurs paramètres de réseau (209) du réseau externe (105).

5. Procédé selon la revendication 1, dans lequel l'étape consistant à optimiser lesdits un ou plusieurs paramètres de réseau (209) est effectuée en :

injectant une ou plusieurs impédances en dérivation dans le réseau simplifié (303) ; et

ajustant des valeurs desdites une ou plusieurs impédances en dérivation pour optimiser lesdits un ou plusieurs paramètres de réseau (209).

6. Système d'estimation (101) pour estimer un ou plusieurs paramètres équivalents (213) pour au moins un réseau externe (105) associé à un réseau interne (104. 301, 401) dans un système électrique (102), ledit système d'estimation (101) comprenant :

un processeur (106, 702) ; et

une mémoire (108, 705) couplée de manière communicative au processeur (106, 702),

dans lequel la mémoire (108, 705) est configurée pour stocker des instructions exécutables par le processeur, qui, lorsqu'elles sont exécutées, sont configurées pour amener le processeur (106, 702) à :

établir un réseau simplifié (303) pour un système électrique (102) comprenant un réseau interne (104. 301, 401) et au moins un réseau externe (105), sur la base d'au moins un élément parmi des variables d'état et des mesures du réseau interne (104. 301, 401) et d'un ou plusieurs bus frontières du système électrique (102), ledit au moins un réseau externe (105) étant représenté sous la forme d'un bus avec une pluralité de variables d'état prédéfinies (502.1, 502.2) pour ledit au moins un réseau externe (105), pour établir le réseau simplifié (303) ;

estimer un ou plusieurs paramètres de réseau (209), tels qu'un flux de puissance ou des variables d'état dans lesdits un ou plusieurs bus frontières, pour ledit au moins un réseau externe (105), sur la base du réseau simplifié (303) et de la pluralité de variables d'état prédéfinies (502.1, 502.2), en utilisant une technique d'optimisation ;

effectuer l'accord desdits un ou plusieurs paramètres de réseau (209) en ce qui concerne les variables d'état et les mesures du réseau interne (104. 301, 401) et desdits un ou plusieurs bus frontières, en effectuant les étapes consistant à :

effectuer une estimation d'état du système électrique (102) en utilisant lesdits un ou plusieurs paramètres de réseau (209) ;

déterminer un résidu associé à l'estimation d'état du système électrique (102), le résidu étant comparé avec une valeur seuil (212) ; et

optimiser lesdits un ou plusieurs paramètres de réseau (209) pour effectuer une nouvelle estimation d'état du système électrique (102) lorsque le résidu est déterminé comme étant supérieur à la valeur seuil (212), l'accord étant effectué jusqu'à ce que le résidu soit déterminé comme étant inférieur à la valeur seuil (212) ; et

fournir lesdits un ou plusieurs paramètres de réseau (209) sous la forme d'un ou plusieurs paramètres équivalents (213) pour ledit au moins un réseau externe (105),
**caractérisé en ce que** l'optimisation desdits un ou plusieurs paramètres de réseau (209) est effectuée en :

divisant le bus pour lesdits un ou plusieurs bus frontières ; et

faisant varier les valeurs desdits un ou plusieurs paramètres de réseau (209) pour chacun desdits un ou plusieurs bus frontières, pour minimiser les résidus associés à au moins une valeur parmi la puissance réelle, la tension, l'angle et la puissance réactive du réseau interne (104. 301, 401) et desdits un ou plusieurs bus frontières.

7. Système d'estimation (101) selon la revendication 6, dans lequel le réseau simplifié (303) pour le système électrique (102) est établi en :

déterminant lesdits un ou plusieurs bus frontières et un flux correspondant de puissance réelle et un flux de puissance réactive associés au réseau interne (104. 301, 401), sur la base de la pluralité de variables d'état du réseau interne (104. 301, 401) ; et

étendant le réseau interne (104. 301, 401) ainsi que lesdits un ou plusieurs bus frontières en utilisant le bus à travers une ou plusieurs impédances.

8. Système d'estimation (101) selon la revendication 7, dans lequel l'étape consistant à optimiser lesdits un ou plusieurs paramètres de réseau (209) est effectuée pour réduire une désadaptation associée à au moins un élément parmi un flux de puissance et des variables d'état dans lesdits un ou plusieurs bus frontières.

9. Système d'estimation (101) selon la revendication 7, dans lequel l'étape consistant à optimiser lesdits un ou plusieurs paramètres de réseau (209) est effectuée sur la base de facteurs de sensibilité associés auxdits un ou plusieurs paramètres de réseau (209) du réseau externe (105).

10. Système d'estimation (101) selon la revendication 7, dans lequel l'étape consistant à optimiser lesdits un ou plusieurs paramètres de réseau (209) est effectuée en :

injectant une ou plusieurs impédances en dérivation dans le réseau simplifié (303) ; et

ajustant des valeurs desdites une ou plusieurs impédances en dérivation pour optimiser lesdits un ou plusieurs paramètres de réseau (209).

100

POWER SYSTEM
**102**

INTERNAL
NETWORK
**104**

AT LEAST ONE
EXTERNAL
NETWORK
**105**

COMMUNICATION NETWORK
**103**

ESTIMATION SYSTEM
**101**

PROCESSOR
**106**

I/O INTERFACE
**107**

MEMORY **108**

MODULES
**109**

DATA
**110**

**Figure 1**

ESTIMATION SYSTEM
**101**

| PROCESSOR **106** | I/O INTERFACE **107** |

MEMORY **108**

MODULES **109**

| SIMPLIFIED NETWORK ESTIMATE MODULE **201** | NETWORK PARAMETERS ESTIMATE MODULE **202** |

| TUNING MODULE **203** | EQUIVALENT PARAMETERS PROVIDE MODULE **204** |

OTHER MODULES **205**

DATA **110**

| INTERNAL NETWORK DATA **206** | EXTERNAL NETWORK DATA **207** |

| BOUNDARY BUS DATA **208** | NETWORK PARAMETERS **209** |

| STATE ESTIMATION DATA **210** | RESIDUAL DATA **211** |

| THRESHOLD VALUE **212** | EQUIVALENT PARAMETERS **213** |

OTHER DATA **214**

**Figure 2**

**Figure 3a**

**Figure 3b**

**402**

**403**

**Figure 4a**

**402**

**403**

**Figure 4b**

**402**

**Figure 4c**

**402**

**Figure 4d**

**Figure 5a**

**Figure 5b**

600

ESTABLISH SIMPLIFIED NETWORK FOR POWER SYSTEM
**601**

ESTIMATE ONE OR MORE NETWORK PARAMETERS FOR AT LEAST ONE EXTERNAL NETWORK, INTERNAL NETWORK, AND ONE OR MORE BOUNDARY BUSES OF POWER SYSTEM
**602**

PERFORM STATE ESTIMATION OF POWER SYSTEM USING ONE OR MORE NETWORK PARAMETERS FOR AT LEAST ONE EXTERNAL NETWORK AND PLURALITY OF STATE VARIABLES OF INTERNAL NETWORK
**603**

DETERMINE A RESIDUAL ASSOCIATED WITH THE STATE ESTIMATION OF THE POWER SYSTEM
**604**

OPTIMIZE ONE OR MORE NETWORK PARAMETERS
**606**

**YES**

IF RESIDUAL IS GREATER THAN THRESHOLD VALUE
**605**

**NO**

PROVIDE ONE OR MORE NETWORK PARAMETERS AS ONE OR MORE EQUIVALENT PARAMETERS
**607**

## Figure 6

**Figure 7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2004083087 A

**Non-patent literature cited in the description**

- A Partitioned State Estimator for External Network Modeling. **GEORGE N KORRES.** IEEE TRANSACTIONS ON POWER SYSTEMS. IEEE SERVICE CENTER, 01 August 2002, vol. 17

- Multi-Area State Estimation with PMU and external system modeling. **EDUARDO WERLEY S DOS ANGELOS et al.** 2012 IEEE POWER AND ENERGY SOCIETY GENERAL MEETING. IEEE, 22 July 2012, 1-7